# EUROPEAN PATENT APPLICATION

(11) **EP 0 690 330 A1**
(43) Date of publication of application: **03.01.1996**
(21) Application number: 95110149.2
(22) Date of filing: 29.06.1995
(51) Int. Cl.: G02B 26/08, H01H 1/00

(54) **improvements in or relating to micro-mechanical devices**

(30) Priority: 30.06.1994 US 268901
(71) Applicant: TEXAS INSTRUMENTS INCORPORATED, Dallas Texas 75265 (US)
(72) Inventor: Wallace, Robert M., Dallas, TX 75243 (US); Gnade, Bruce E., Dallas, TX 75243 (US); Webb, Douglas A., Chandler, AZ 85224 (US)
(74) Representative: Schwepfinger, Karl-Heinz, Dipl.-Ing.

(57) **Abstract**

A method of forming of a monomolecular layer (monolayer) (19) for surfaces of contacting elements (17) of a micro-mechanical device (10). The method includes providing a coordinating substance on the surface of one of the contacting elements (13), then depositing a precursor substance (51) for formation of the monolayer (19). The coordinating substance (33) and the precursor substance (51) are chosen based on molecular recognition chemistry.

## Description

### TECHNICAL FIELD OF THE INVENTION

This invention relates to micro-mechanical devices, and more particularly, to such devices having contacting elements and to a method for preventing sticking of these contacting elements.

### BACKGROUND OF THE INVENTION

A recent development in the field of electro-mechanics has been the miniaturization of various mechanical devices. Typical of such devices are tiny gears, levers, and valves. These "micro-mechanical" devices are manufactured using integrated circuit techniques, often together with electrical control circuitry. Common applications include accelerometers, pressure sensors, and actuators. As another example, spatial light modulators can be configured from micro-mechanical pixels.

One type of micro-mechanical spatial light modulator is a digital micro-mirror device (DMD), sometimes referred to as a deformable mirror device. The DMD has an array of hundreds or thousands of tiny tilting mirrors. Light incident on the DMD is selectively reflected or not reflected from each mirror to an image plane, to form images. To permit the mirrors to tilt, each is attached to one or more hinges mounted on support posts, and spaced by means of an air gap over underlying control circuitry. The control circuitry provides electrostatic forces, which cause each mirror to selectively tilt. In many DMDs, an edge of the mirror contacts a landing electrode, which serves as a stop.

Reliability has been difficult to achieve with micro-mechanical devices. A common reliability problem is the sticking that may occur when moveable elements contact each other. If such elements stick together, the device ceases to operate properly. In the case of a DMD, the deflected mirror can become stuck to the landing electrode.

Many previous approaches to preventing sticking of contacting elements of micro-mechanical devices have been directed to coating the surfaces of contacting elements. The application of a layer of polymeric material is described in (TI-18468), U.S. Patent Serial No. 08/216,194, entitled "Polymeric Coatings for Micromechanical Devices". The application of a layer of perfluoropolyether material is described in U.S. Patent Serial No. 08/239,497, entitled "PFPE Coatings for Micro-Mechanical Devices" (Atty Dkt No. TI-18478). It has also been discovered that a monomolecular layer (monolayer) of an appropriate substance may result in a reduction of friction between the contacting elements, thereby reducing the possibility of sticking. U.S. Patent Serial No. 07/823,580 (TI-15692), entitled "Low Reset Voltage Process for DMD", describes a method of providing a monolayer by means of vapor deposition.

### SUMMARY OF THE INVENTION

One aspect of the invention is an improved micro-mechanical device of a type having relatively moving elements, fabricated on a substrate, portions of which may come into contact with each other and thereafter adhere together at their contacting surfaces. The improvement comprises a monomolecular layer (monolayer) on at least one of the contacting surfaces. The monolayer is formed by providing a contacting surface that is made from a "coordinating substance", that is, a substance known to react with a subsequently deposited molecular precursor substance so as to form the monolayer. The coordinating substance and the precursor substance are selected on the basis of a molecular recognition chemistry that results in a monolayer only on surfaces made from the coordinating substance. As an example of such molecular recognition, the contacting surface may be gold-coated and the precursor a sulfur-bearing substance such as an alkanethiol. Even if the precursor is deposited over the entire substrate, the monolayer forms only on the gold surface.

An advantage of the invention is that it provides a coating that is thermally and chemically stable. The coating is selective and is only formed only on surfaces coated with the coordinating substance.

The specific combination of coordinating substance and precursor substance can be chosen to give improved chemical stability compared to that available without a deliberate choice for these two substances. For example, in a DMD, if the contacting surface is composed of a reactive metal, such as the oxidized surface of aluminum, certain perfluorinated lubricants will degrade chemically. Also, the specific combination of coordinating substance and precursor substance can be chosen to give improved quality of the monomolecular coating, indicating higher packing density and lower defect levels, compared to that available without a deliberate choice for these two substances. This should provide better performance.

### BRIEF DESCRIPTION OF THE DRAWINGS

Figure 1 illustrates an undeflected mirror element of one type of micro-mechanical device, a digital micro-mirror device (DMD), made in accordance with the invention.

Figure 2 illustrates the mirror element of Figure 1 in a deflected position.

Figures 3 - 6 illustrate the steps of the method of the invention.

### DETAILED DESCRIPTION OF THE INVENTION

For purpose of example, the following description is in terms of a particular type of micro-mechanical device, a "digital micro-mirror device" (DMD), sometimes also referred to as a "deformable mirror device". As described in the Background, one application of DMDs is for forming images, where the DMD has an array of deflectable mirrors that selectively reflect light to an image plane. The images formed by the DMD can be used in display systems or for non-impact printing applications. Other applications of DMDs are possible that do not involve image formation, such as optical steering, optical switching, and accelerometers. In some of these applications, such as an accelerometer the "mirror" need not be reflective and the applied force is due to acceleration rather than electrostatic. Also, in some applications, the DMD is not necessarily operated in a digital mode.

In general, the term "DMD" is used herein to include any type of micro-mechanical device having at least one hinged and deflectable mass that is spaced by an air (or other gas, or vacuum) gap from a substrate, which it contacts in response to an applied force. The invention is used during fabrication of the DMD to coat contacting surfaces of the mirror elements and the surfaces upon which they land.

The invention is useful for other types of micro-mechanical devices that have moveable elements. Like the DMD's tilting mirrors, other micro-mechanical devices may have tiny rotors, levers, or other moving parts that come into contact with other surfaces during operation of the micro-mechanical device, thereby giving rise to the possibility of sticking.

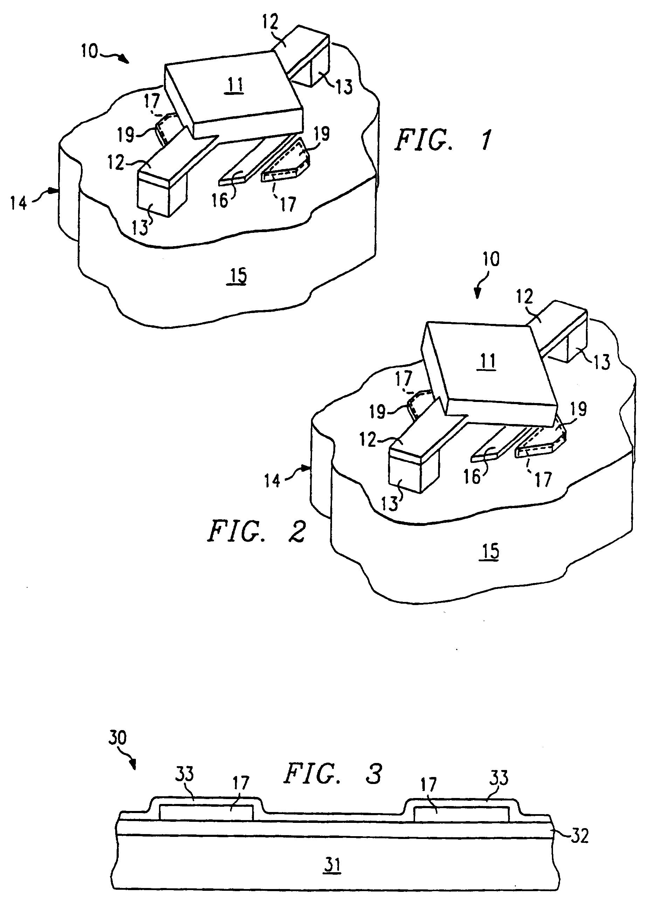

Figures 1 and 2 illustrate a single mirror element 10 of a DMD. In Figure 1, the mirror 11 is undeflected, whereas in Figure 2, the mirror 11 is deflected by being tilted toward a landing electrode 17. As indicated above, various DMD applications may use such mirror elements 10 singly or in arrays.

The mirror element 10 of Figures 1 and 2 is known as a "torsion beam" element. Other types of mirror elements 10 can be fabricated, including cantilever beam types and flexure beam types. Various DMD types are described in U.S. Patent No.4,662,746, entitled "Spatial Light Modulator and Method"; U.S. Patent No. 4,956,610, entitled "Spatial Light Modulator"; U.S. Patent No. 5,061,049 entitled "Spatial Light Modulator and Method"; U.S. Patent No. 5,083,857 entitled "Multi-level Deformable Mirror Device"; and (TI-17708) U.S. Patent Serial No. 08/097,824. Each of these patents is assigned to Texas Instruments Incorporated and each is incorporated herein by reference.

In operation for image display applications, a light source illuminates the surface of the DMD. A lens system may be used to shape the light to approximately the size of the array of mirror elements 10 and to direct this light toward them. Each mirror element 10 has a tilting mirror 11 supported by torsion hinges 12 attached to support posts 13. These support posts 13 are formed on and extend away from the substrate 15. The mirrors 11 are positioned over a control circuit 14, which is comprised of address and memory circuitry fabricated on the substrate 15.

Voltages based on data in the memory cells of control circuit 14 are applied to two address electrodes 16, which are located under opposing corners of mirror 11. Electrostatic forces between the mirrors 11 and their address electrodes 16 are produced by selective application of voltages to the address electrodes 16. The electrostatic force causes each mirror 11 to tilt either about +10 degrees (on) or about -10 degrees (off), thereby modulating the light incident on the surface of the DMD. Light reflected from the "on" mirrors 11 is directed to an image plane, via display optics. Light from the "off" mirrors is reflected away from the image plane. The resulting pattern forms an image. The proportion of time during each image frame that a mirror 11 is "on" determines shades of grey. Color can be added by means of a color wheel or by a three-DMD setup.

In effect, the mirror 11 and its address electrodes 16 form capacitors. When appropriate voltages are applied to mirror 11 and its address electrodes 16, a resulting electrostatic force (attracting or repelling) causes the mirror 11 to tilt toward the attracting address electrode 16 or away from the repelling address electrode 16. The mirror 11 tilts until its edge contacts an underlying landing electrode 17.

Once the electrostatic force between the address electrodes 16 and the mirror 11 is removed, the energy stored in the hinge 12 provides a restoring force to return the mirror 11 to an undeflected position. Appropriate voltages may be applied to the mirror 11 or address electrodes 16 to aid in returning the mirror 11 to its undeflected position.

As illustrated in Figures 1 and 2, mirror element 10 has a layer 19 on the exposed surface of landing electrode 17. This layer 19 is referred to herein as a "monomolecular layer" (monolayer), defined as a film that has a thickness that is approximately the length of the molecules that constitute layer 19.

Figures 3 - 6 illustrate the method aspects of the invention, used to form monolayer 19. For purposes of example, the method of the invention is described in terms of fabricating mirror elements 10 of a DMD 30 of the type described above. However, the method could be performed during fabrication of any other micro-mechanical device having at least one moveable element.

Regardless of the type of micro-mechanical device on which the method is performed, the method assumes that at least one contacting surface has been fabricated. Accordingly, in Figure 3, DMD 30 is now fabricated to the level of landing electrodes 17. In a typical DMD 30, to reach this level of fabrication, an oxide layer 32 has been grown on a substrate 31. A 3000 angstrom layer of Ti:Si:Al (0.2% titanium and 1% silicon) has been deposited on oxide layer 32, then patterned and etched to define electrodes 17.

A coordinating layer 33 of a "coordinating substance" has been deposited over electrodes 17. As explained below, the "coordinating substance" is designated as such because it is a substance especially selected to react with a subsequently deposited precursor substance to form a monolayer. The deposition of layer 33 may be by conventional means, such as sputtering.

In the example of this description, coordinating layer 33 is made from gold, silver, copper, or platinum. If layer 33 is gold and if electrical circuitry underlies electrodes 17, care should be exercised to confine the deposition to the level of electrodes 17. This is because gold can cause deep level traps in underlying silicon-based circuitry, thereby reducing minority carrier lifetimes. In this regard, a titanium-tungsten diffusion barrier may be effective to prevent adverse effects of the gold deposition.

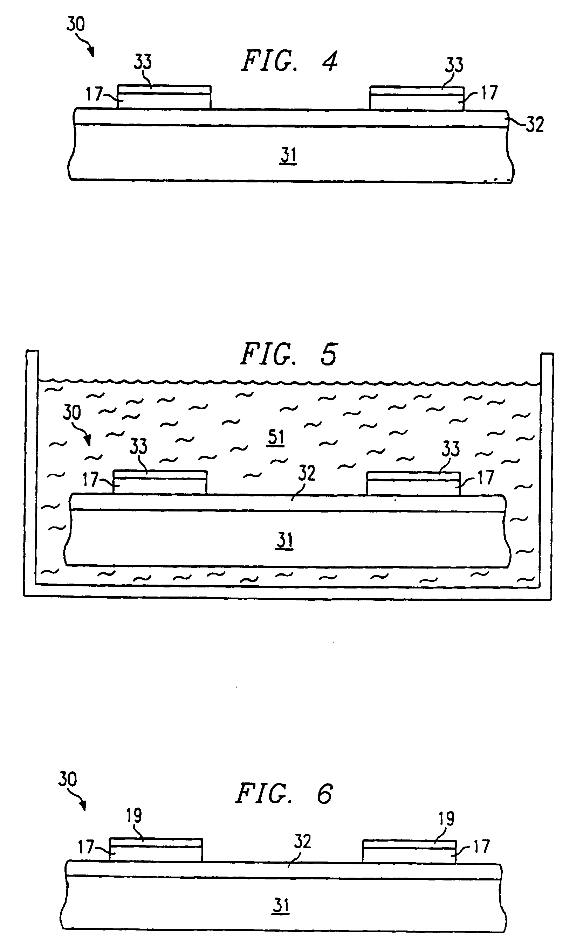

In Figure 4, residual of coordinating layer 33 has been removed from between electrodes 17. This may be accomplished by an etch or lift-off process.

The DMD 30 may then be cleaned to remove contaminants as a prelude to deposition of the precursor. However, an advantage of using a noble metal such as gold or platinum for layer 33 is that noble metals are inert to contaminants and do not readily form oxides. Thus, cleaning is optional. If performed, cleaning may entail conventional cleaning techniques, using dry processing or solution-based processing.

As an alternative to the steps of Figures 3 and 4, before electrodes 17 are patterned and etched, coordinating layer 33 could be deposited over the metal layer used to form electrodes 17. Then, layer 33 would be patterned and etched together with electrodes 17.

As another alternative to the steps of Figures 3 and 4, the entire material for landing electrodes 17 could be the coordinating substance. For example, gold is a suitable material for fabricating landing electrodes 17 and is also a suitable coordinating substance for certain precursors. Also, existing DMDs fabricate their landing electrodes 17 from aluminum, which is a suitable coordinating substance for certain other precursors.

The steps of Figures 3 and 4 may be generally characterized as providing at least one contacting surface that is made from a coordinating substance. It is not important to the invention whether this requires an extra layer of the coordinating substance or whether the contacting surface is made entirely of the coordinating substance.

In Figure 5, a precursor substance 51 is deposited onto the DMD surfaces. Typically, the deposition will be a liquid deposition. U.S. Patent Serial No. 08/268,485, entitled "Self-Assembled Monolayer Coating for Micro-Mechanical Devices" (Atty Dkt No. TI-18476), assigned to Texas Instruments Incorporated and incorporated by reference herein, describes a method of providing a self-assembled monolayer by liquid deposition. It may also be possible to achieve molecular recognition for a self-assembled monolayer by nebulizing the precursor in droplets of a solvent.

A feature of the invention is the selection of a molecular precursor 51 based on a coordination chemistry between the precursor and the surface to the coated. This coordination chemistry is referred to herein as "molecular recognition" in that the chemically active functional group on the molecular precursor reacts exclusively with (recognizes) the coordinating substance. As a result of proper selection in accordance with the invention, the coordinating substance on the surface to be coated reacts only with the precursor 51.

As explained in further detail below, the surface to be coated may well include an oxide layer, either from exposure to atmosphere or processing. The surface chemistry of the precursor species usually involves the presence of such oxides, especially in the case of aluminum surfaces. Noble metal surfaces, where oxides are ideally not present, require other precursor species.

Suitable molecular precursors for self-assembly in solution have generally three properties associated with their chemical constituents. First, a surface-active functional group serves to react and thereby anchor the remainder of the molecule to the coordinating substance on the surface to be coated. Second, an alkyl or derivatized-alkyl chain extends from the coordinating substance and interacts with other neighboring precursor chains through repulsive van der Waals interactions, thus serving to permit packing of the molecular precursors into a dense film. Third, a terminating functional group effectively serves as the surface of the deposited monolayer film. The self-assembled monolayer process is generally described in A. Ulman, An Introduction to Ultrathin Organic Films, pp. 237 - 338 (Academic Press, Inc. 1991).

For surfaces whose coordinating substance is gold, suitable precursors 51 are sulfur-bearing, such as alkanethiols and dialkyldithiols, both referred to herein as thiols. Other suitable precursors for gold surfaces are alkyl-phosphines or arsines. For surfaces whose coordinating substance is silver oxide, suitable precursors include phosphonic acids, n-alkanoic (also called carboxylic) acids, and alkyl thiols. For surfaces whose coordinating substance is platinum, suitable precursors are alcohols, amines, and n-alkanoic acids. Un-oxidized silver and copper coordinating surfaces call for sulfur-bearing precursors.

As stated above, the surface upon which the monolayer is to be formed may be already made from a coordinating substance without the need for an extra layer 33. In the case of a DMD 30, instead of depositing layer 33 over electrodes 17, molecular recognition could be used to select a coordinating substance from which electrodes 17 are to be fabricated. For example, electrodes 17 could be made from aluminum oxide. For aluminum oxide surfaces, suitable precursors are phosphorus-bearing, such as phosphonic acids. Other examples are alkyl oxalic acids, hydroxamic acids, sulfates, amines, and alcohols. Another specific example is an n-alkanoic acid.

For purposes of this description, designation of the above-mentioned precursors is meant to include any perhalogenated variants. For example, n-alkanoic acids and phosphonic acids could be perfluorinated for improved anti-adhesion and lubricative results.

A feature of the invention, when the coordinating substance is provided as an extra layer on the contacting element, is that it can provide a surface that is dissimilar to the surface it contacts. This use of dissimilar materials can be expected to ameliorate adhesion of the contacting elements if the monolayer 19 wears away or becomes discontinuous.

Figure 6 illustrates the results of the deposition of Figure 5 and the reaction of the precursor 51 with coordinating substance. A monolayer 19 has formed on the surfaces that were coated with the coordinating substance, the surfaces of electrodes 17. As is typical of a monolayer formed by liquid deposition, the chemically active functional groups of the precursor molecules 51 are bound to the surface of electrodes 17. The precursor molecules have aligned themselves with their functional groups being bound to the coordinating substance on the surface of electrodes 17.

In some micro-mechanical devices, the contacting surfaces may be of different materials. For example, in the case of a DMD, it may be practicable to fabricate or coat electrodes 17 with a coordinating substance such as gold. However, for various reasons, the underside of mirror 11 is preferably a harder metal, such as titanium-tungsten or an aluminum alloy. In this case, the process of Figures 3 - 6 could be repeated with a different precursor substance 51 for each of the two different contacting surfaces 17 and 11. Each precursor substance recognizes and sticks to only its coordinating substance. Thus, a first precursor 51 would be deposited to form a monolayer on electrodes 17. Then, a second precursor 51 could be deposited to form a monolayer on the underside of mirror 11.

### Other Embodiments

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A micro-mechanical device of a type having relatively moving elements fabricated on a substrate, portions of which may come into contact with each other and thereafter adhere together at their contacting surfaces, wherein the device comprises:
a layer on at least one contacting surface, said layer having been formed by a chemical reaction between a coordinating substance on that contacting surface and a precursor substance deposited on said substrate, wherein said coordinating substance and said precursor substance are selected on the basis of molecular recognition such that deposition of said precursor on said substrate forms said layer only on said at least one contacting surface.

2. The device of claim 1, wherein the layer is a mono-molecular layer.

3. The device of Claim 1 or Claim 2, wherein said coordinating substance is selected primarily from the group containing gold aluminium oxide, silver oxide, platinum, copper, silver and noble metals.

4. The device of any preceding Claim, wherein the precursor is selected from the group containing an alkanethiol, dialkyl-sulphides, dialkyl-disulphides, phosphorus bearing compounds, an n-alkanoic acid, a sulphur bearing compound, a carboxylic acid, phosphine.

5. A method of preventing sticking of contacting elements of a micro-mechanical device having contacting elements, comprising the steps of:
at least partially fabricating said micro-mechanical device, such that at least of said contacting elements is substantially fabricated, its surface made from a coordinating substance selected on the basis of a molecular recognition chemistry such that said coordinating substance will react with a certain precursor to form a monomolecular layer on said surface; and
exposing said surface to a solution containing a precursor substance, such that molecules of said precursor substance bind to said surface as a self-assembled monolayer.

6. The device of Claim 5, wherein said coordinating substance is selected primarily from the group containing gold aluminium oxide, silver oxide, platinum, copper, silver and noble metals.

7. The device of Claim 5 or Claim 6, wherein the precursor is selected from the group containing an alkanethiol, dialkyl-sulphides, dialkyl-disulphides, phosphorus bearing compounds, an n-alkanoic acid, a sulphur bearing compound, a carboxylic acid, phosphine.

8. A digital micro-mirror device, comprising:
a substrate upon which the following elements are fabricated: at least one landing electrode, a support post, a hinge extending from said support post, a mass attached to said hinge, wherein said hinge is deformable so as to permit said mass to contact said landing electrode upon being subjected to an applied force; and
wherein the contacting surface of said mirror or of said landing electrode, or both of said surfaces, are made from a coordinating substance selected on the basis of coordination chemistry such that when a precursor substance is deposited on said coordinating substance a resulting reaction will form a monomolecular layer on said surface.
